# EUROPÄISCHE PATENTSCHRIFT

(11) **EP 1 939 442 B1**
(45) Veröffentlichungstag und Bekanntmachung des Hinweises auf die Patenterteilung: **13.02.2013**
(21) Anmeldenummer: 07121319.3
(22) Anmeldetag: 22.11.2007
(51) Int. Cl.: H01L 41/053, F02M 51/06, F02M 61/16

(54) **Brennstoffeinspritzventil**
Fuel injector valve
Soupape d'injection de combustible

(30) Priorität: 29.12.2006 DE 102006062562
(43) Veröffentlichungstag der Anmeldung: 02.07.2008
(73) Patentinhaber: ROBERT BOSCH GMBH, 70442 Stuttgart (DE)
(72) Erfinder: Rapp, Holger, 71254, Ditzingen (DE)

(56) Entgegenhaltungen:
- WO-A-03/009400
- DE-A1-102005 008 718
- US-A- 4 553 059

## Beschreibung

### Stand der Technik

Die Erfindung betrifft ein Brennstoffeinspritzventil für Brennstoffeinspritzanlagen von Brennkraftmaschinen. Speziell betrifft die Erfindung einen Injektor für Brennstoffeinspritzanlagen von luftverdichtenden, selbstzündenden Brennkraftmaschinen.

DE 10 2005 008 718 A1 offenbart ein Aktormodul mit einen Aktorfuß, der aus einem Verbundmaterial, vorzugsweise ein Pulververbundmaterial 23 hergestellt ist.

Aus der WO 03/026033 A1 ist eine Vorrichtung für ein Brennstoffeinspritzventil mit einem piezoelektrischen Aktor bekannt. Dabei weist die Vorrichtung metallische Platten auf, zwischen denen der piezoelektrische Aktor angeordnet ist. Beim Einbau der Vorrichtung mit dem piezoelektrischen Aktor in ein Brennstoffeinspritzventil dient der piezoelektrische Aktor zum Betätigen eines Ventilschließkörpers, um die Abspritzung von Brennstoff zu ermöglichen.

Die aus der WO 03/026033 A1 bekannte Vorrichtung mit dem piezoelektrischen Aktor hat den Nachteil, dass diese ein nur geringfügig gedämpftes, schwingungsfähiges Gebilde darstellt, das im Betrieb des Brennstoffeinspritzventils in einem hörbaren, hohen Frequenzspektrum schwingt. Die Schwingungen übertragen sich dabei auf den Zylinderkopf des Motors, so dass deutlich hörbare Geräusche entstehen, die speziell von den Insassen als störend empfunden werden können.

### Offenbarung der Erfindung

Das erfindungsgemäße Brennstoffeinspritzventil mit den Merkmalen des Anspruchs 1 hat demgegenüber den Vorteil, dass unangenehme Schaltgeräusche verhindert oder zumindest verringert sind.

Durch die in den Unteransprüchen aufgeführten Maßnahmen sind vorteilhafte Weiterbildungen des im Anspruch 1 angegebenen Brennstoffeinspritzventils möglich.

In vorteilhafter Weise kann das gepresste Pulver eine geringe Elastizität aufweisen, so dass zwar eine wirkungsvolle Dämpfung der bei den Schaltvorgängen auftretenden Schwingungen gewährleistet ist, die Funktion des Brennstoffeinspritzventils, insbesondere die Steifigkeit des Betätigungsmoduls, jedoch nicht wesentlich beeinträchtigt ist.

In vorteilhafter Weise ist zumindest ein elastischer Dichtring, insbesondere ein O-Ring, zwischen einem Übergangsstück und einem Ventilgehäuse vorgesehen, der ein Volumen begrenzt, in dem das gepresste Pulver angeordnet ist. Die elastischen Dichtringe ermöglichen dabei zum einen eine zuverlässige Abdichtung des Volumens, in dem das gepresste Pulver vorgesehen ist, und zum anderen eine einfache Montage des Brennstoffeinspritzventils. Hierbei kann bei der Montage des Aktors, an den die Übergangsstücke bereits angefügt sind, eine Verdichtung des vorher eingefüllten Pulvers erfolgen. Dabei ist es auch vorteilhaft, dass die Verpressung des Pulvers über eine Vorspannkraft erfolgt, die zum Vorspannen des Aktors dient und beispielsweise von einer Druckfeder oder einem anderen Federelement erzeugt ist.

Vorteilhaft ist es, dass das Übergangsstück abschnittsweise von einer Hülse umgeben ist, wobei der Dichtring an einer Auskragung der Hülse abgestützt ist. Die Hülse kann dabei einerseits an einem als Aktorfuß ausgestalteten Übergangsstück und andererseits an einem als Aktorkopf ausgestalteten Übergangsstück befestigt sein. Die Hülse kann dabei zugleich zur Abdichtung des piezoelektrischen Aktors gegenüber Medien, insbesondere Dieselbrennstoff, dienen.

In vorteilhafter Weise ist der Dichtring teilweise in eine ringförmige Nut des Aktorfußes eingesetzt. Dadurch ist ebenfalls eine zuverlässige Begrenzung des Volumens, in dem das gepresste Pulver vorgesehen ist, und eine einfache Montage des Brennstoffeinspritzventils gewährleistet.

Das Pulver kann vollständig oder teilweise als metallisches Pulver und/oder als nicht metallisches Pulver ausgebildet sein. Als metallisches Pulver eignet sich speziell ein Eisenpulver, ein Stahlpulver und/oder ein Aluminiumpulver. Als nicht metallisches Pulver eignet sich ein Pulver aus einem Siliciumoxid, das heißt SiOx oder eine Mischung aus verschiedenen Siliciumoxiden, oder andere nicht metallische Pulver, die eine ausreichende Festigkeit und Medienbeständigkeit, insbesondere gegenüber Dieselbrennstoff, gewährleisten. Ebenfalls geeignet sind Pulver aus Magnesiumoxid, Aluminiumoxid oder andere Metalloxide.

In vorteilhafter Weise liegt die Partikelgröße des Pulvers unter 0,5 mm. Dabei können auch sehr kleine Partikel vorgesehen sein, insbesondere Nanopartikel. Das Pulver kann auch aus verschiedenen Pulvern mit unterschiedlichen Partikelgrößen gemischt sein.

### Kurze Beschreibung der Zeichnungen

Bevorzugte Ausführungsbeispiele der Erfindung sind in der nachfolgenden Beschreibung anhand der beigefügten Zeichnungen, in denen sich entsprechende Elemente mit übereinstimmenden Bezugszeichen versehen sind, näher erläutert. Es zeigt:
Fig. 1 ein erstes Ausführungsbeispiel eines erfindungsgemäßen Brennstoffeinspritzventils in einer schematischen Schnittdarstellung und
Fig. 2 den in Fig. 1 mit II bezeichneten Ausschnitt eines Brennstoffeinspritzventils gemäß einem zweiten Ausführungsbeispiel in einer schematischen Darstellung.

### Ausführungsformen der Erfindung

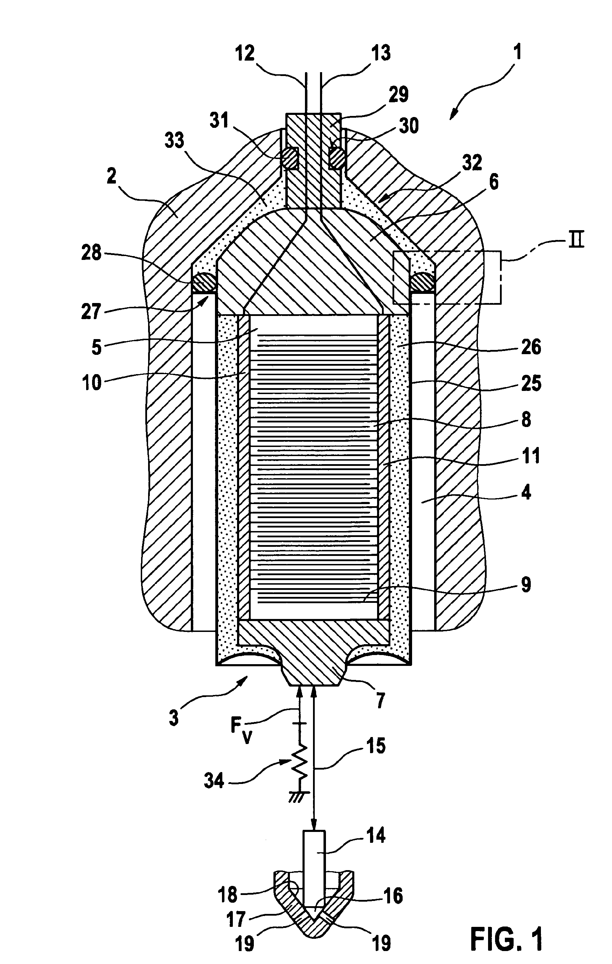

Fig. 1 zeigt ein Brennstoffeinspritzventil 1 entsprechend einem ersten Ausführungsbeispiel der Erfindung. Das Brennstoffeinspritzventil 1 kann insbesondere als Injektor für Brennstoffeinspritzanlagen von luftverdichtenden, selbstzündenden Brennkraftmaschinen dienen. Ein bevorzugter Einsatz des Brennstoffeinspritzventils 1 besteht für eine Brennstoffeinspritzanlage mit einem Common-Rail, das Dieselbrennstoff unter hohem Druck zu mehreren Brennstoffeinspritzventilen 1 führt. Das erfindungsgemäße Brennstoffeinspritzventil 1 eignet sich jedoch auch für andere Anwendungsfälle.

Das Brennstoffeinspritzventil 1 weist ein Ventilgehäuse 2 und einen in dem Ventilgehäuse 2 angeordneten piezoelektrischen Aktor 3 auf. Der piezoelektrische Aktor 3 ist dabei in einem Aktorraum 4 im Inneren des Ventilgehäuses 2 angeordnet. Der piezoelektrische Aktor 3 weist einen Aktorkörper 5 auf, an den metallische Übergangsstücke 6, 7 angefügt sind. Das Übergangsstück 6 ist dabei als Aktorfuß ausgestaltet und das Übergangsstück 7 ist als Aktorkopf ausgestaltet. Der Aktorkörper 5 weist eine Vielzahl von keramischen Schichten 8 und eine Vielzahl von zwischen den keramischen Schichten 8 angeordneten Elektrodenschichten 9 auf. Die Elektrodenschichten 9 sind dabei abwechselnd mit einer ersten Außenelektrodenanbindung 10 und einer zweiten Außenelektrodenanbindung 11 verbunden. Die Außenelektrodenanbindungen 10, 11 sind mit elektrischen Leitungen 12, 13 verbunden, die durch den Aktorfuß 6 geführt sind. Durch Anliegen einer elektrischen Spannung zwischen elektrischen Leitungen 12, 13 kann eine Beaufschlagung des piezoelektrischen Aktors 3 erfolgen, die zu einer Dehnung des Aktorkörpers 5 führt. Diese Dehnung wird über das Übergangsstück 7 direkt oder mittelbar auf eine Ventilnadel 14 übertragen, wie es durch den Wirkungspfeil 15 veranschaulicht ist. Ein mit der Ventilnadel 14 verbundener Ventilschließkörper 16, der mit einer an einem Ventilsitzkörper 17 ausgebildeten Ventilsitzfläche 18 zu einem Dichtsitz zusammenwirkt, gibt dadurch zumindest eine Düsenöffnung 19 frei oder verschließt diese. Dadurch kann die Abgabe eines durch das Ventilgehäuse 2 zu dem Ventilsitzkörper 17 geleiteten Brennstoffs gesteuert werden.

Der Aktor 3 weist eine Hülse 25 auf, die einerseits mit dem Aktorfuß 6 und andererseits mit dem Aktorkopf 7 verbunden ist. Ein Zwischenraum zwischen der Hülse 25 und dem Aktorkörper 5 ist vollständig oder teilweise mit einer Vergussmasse 26 gefüllt. Die Hülse 25 weist außerdem im Bereich des als Aktorfuß ausgestalteten Übergangsstücks 6 eine Auskragung 27 auf, an der sich ein Dichtring 28 abstützt. Ferner ist an einem zylinderförmigen Abschnitt 29 des Aktorfußes 6 eine ringförmige Nut 30 vorgesehen, in die ein weiterer Dichtring 31 teilweise eingesetzt ist. Durch die beiden Dichtringe 28, 31 ist ein Volumen 32 zwischen dem Aktorfuß 6 und dem Ventilgehäuse 2 abgedichtet und begrenzt. Dieses Volumen 32 ist mit einem verpressten Pulver 33 aufgefüllt.

Das Brennstoffeinspritzventil 1 weist ein Vorspannelement 34 auf, das zum Vorspannen des Aktors 3 dient. Das Vorspannelement 34 erzeugt eine Vorspannkraft FV, mit der der Aktorkörper 5 im Ausgangszustand beaufschlagt ist. Die Vorspannkraft FV bedingt dabei zugleich eine Verpressung des Pulvers 33 in dem Volumen 32. Das Pulver 33 ist zwischen dem Aktorfuß 6 und dem Ventilgehäuse 2 vorgesehen, so dass der Aktorfuß 6 nirgends direkt an dem Ventilgehäuse 2 anliegt. Somit ist der Aktorfuß 6 in dem gepressten Pulver 33 an dem Ventilgehäuse 2 gelagert. Bei einer Betätigung des Aktors 3 durch Anlegen einer elektrischen Spannung zwischen die Leitungen 12, 13 erfolgt eine Dehnung des Aktorkörpers 5 entgegen der Vorspannkraft FV, wobei sich der Aktor 3 über den in dem gepressten Pulver 33 gelagerten Aktorfuß 6 an dem Ventilgehäuse 2 abstützt. Somit erfolgt eine mittelbare Abstützung des Aktors 3 an dem Ventilgehäuse 2, nämlich mittels des gepressten Pulvers 33.

Da der piezoelektrische Aktor 3 bei der Betätigung zwar sehr hohe Kräfte ausüben kann, in der Regel aber nur einen sehr geringen Leerlaufhub aufweist, kommt der Steifigkeit der Abstützung des Aktors 3 an dem Ventilgehäuse 2 eine hohe Bedeutung für die Funktion des Brennstoffeinspritzventils 2 zu. Falls diese Anbindung zu weich ist, dann kommt es zu einer elastischen Verformung der Übertragungsglieder, so dass der Hub des Aktors 3 zumindest teilweise kompensiert ist und die Längsdehnung des Aktorkörpers 5 beziehungsweise die Längsverkürzung des Aktorkörpers 5 weitgehend wirkungslos bleibt. Die Übergangsstücke 6, 7 sind daher möglichst inelastisch ausgestaltet, beispielsweise aus einem Metall, wobei eine passgenaue Anfügung der Übergangsstücke 6, 7 an den Aktorkörper 5 bewerkstelligt ist. Durch die Vorspannung des piezoelektrischen Aktors 3 mit der Vorspannkraft Fᵥ bilden die Bauteile des Aktors 3 funktional eine Einheit, wobei die mechanischen Kontaktstellen stets kraftschlüssig miteinander verbunden sind. Allerdings besteht das Problem, dass der Aktor 3 ein nur geringfügig gedämpftes, schwingungsfähiges Gebilde (Modul) darstellt, das nach jeder Betätigung über einen relativ langen Zeitraum nachschwingt. Diese Schwingungen können sich im Betrieb des Brennstoffeinspritzventils über eine Pratzung des Brennstoffeinspritzventils auf den Zylinderkopf des Motors übertragen, wodurch deutlich hörbare Geräusche in einem hohen Frequenzspektrum, beispielsweise im Bereich von cirka 8 kHz auftreten, die von Fahrzeuginsassen als störend empfunden werden können.

Durch das gepresste Pulver 33, das eine relativ geringe Korngröße aufweist, ist ein Dämpfungsglied gebildet, das die Ausbildung solch unangenehmer Schaltgeräusche verhindert oder zumindest deutlich verringert.

Die Dichtringe 28, 31, die das Volumen 32 begrenzen, verhindern dabei sowohl bei der Montage als auch im Betrieb, dass ein Teil des Pulvers 33 seitlich unter dem als Aktorfuß ausgestalteten Übergangsstücks 6 hervorgepresst wird, so dass ein unmittelbarer mechanischer Kontakt zwischen dem Aktorfuß 6 und dem Ventilgehäuse 2 über die Lebensdauer des Brennstoffeinspritzventils 1 verhindert ist. Das gepresste Pulver 33, das durch die Vorspannkraft Fᵥ über die Lebensdauer des Brennstoffeinspritzventils 1 zuverlässig verpresst ist, gewährleistet eine steife Anbindung des piezoelektrischen Aktors 3 an dem Ventilgehäuse 2, da sich die einzelnen Körner des Pulvers 33 gegeneinander verkeilen und während der Schaltvorgänge ihre Position zumindest im Wesentlichen nicht verändern. Für die Ausbildung von Resonanzschwingungen des Aktors 3 und gegebenenfalls weiterer Anbauteile im Anschluss an die Schaltvorgänge bildet das mit dem gepressten Pulver 33 gefüllte Volumen 32 ein Dämpfungsglied, so dass die Ausbildung unangenehmer Schaltgeräusche zumindest im Wesentlichen vollständig unterbleibt.

Zur Montage des Brennstoffeinspritzventils 1, insbesondere des Aktors 3, kann zunächst die in dem Ventilgehäuse 2 bestehende Öffnung, in der nachher der zylinderförmige Abschnitt 29 des Aktorfußes 6 angeordnet ist, ein Stift mit geringem Spiel geführt werden. Anschließend kann der Raum um den Stift an der Innenseite des Ventilgehäuses 2, das heißt in dem Aktorraum 4, mit einer definierten Menge eines Lagerpulvers gefüllt werden, das im verpressten Zustand das Pulver 33 bildet. Dann wird der Aktor 3, der als Aktormodul ausgestaltet sein kann, auf den Stift aufgesetzt und unter Herausziehen des Stiftes so eingeführt, dass der zylinderförmige Abschnitt 29 in die in der Fig. 1 dargestellten Position gelangt. Dabei ist bereits der Dichtring 28 auf die Auskragung 27 der Hülse 25 aufgesetzt.

Nachdem der Aktor 3 vollständig auf dem Lagerpulver aufsitzt, kann der Stift vollständig entfernt werden. Der Aktor 3 wird nun weiter gegen das Ventilgehäuse 2 gepresst werden, so dass das Lagerpulver verdichtet wird, bis das Volumen 32 zwischen den beiden Dichtringen 28, 31 vollständig mit dem Pulver 33 gefüllt ist. Anschließend kann mit den normalen Einmess- und Montageprozessen fortgefahren werden. Bei der Montage des Vorspannelements 34 erfolgt dann eine zusätzliche Beaufschlagung des Pulvers 33 mit der Vorspannkraft Fᵥ, so dass das Pulver 33 verpresst ist.

Das gepresste Pulver 33 kann vollständig oder teilweise als metallisches Pulver ausgebildet sein, wobei speziell ein Eisenpulver und/oder ein Stahlpulver und/oder ein Aluminiumpulver verwendet werden kann. Das gepresste Pulver 33 kann auch vollständig oder teilweise als nicht metallisches Pulver ausgebildet sein, wobei insbesondere ein oder mehrere Siliciumoxide, Magnesiumoxide und/oder Aluminiumoxide zum Einsatz kommen können. Die Partikelgröße des gepressten Pulvers 33 kann in Bezug auf den jeweiligen Anwendungsfall gewählt werden und liegt vorzugsweise unter 0,5 mm. Dabei können auch sehr kleine Partikel für das gepresste Pulver 33 zum Einsatz kommen, insbesondere Nanopartikel. Zur Auffüllung eines relativ großen Volumens 32 kann auch eine Mischung von verschiedenen Partikelgrößen von Vorteil sein.

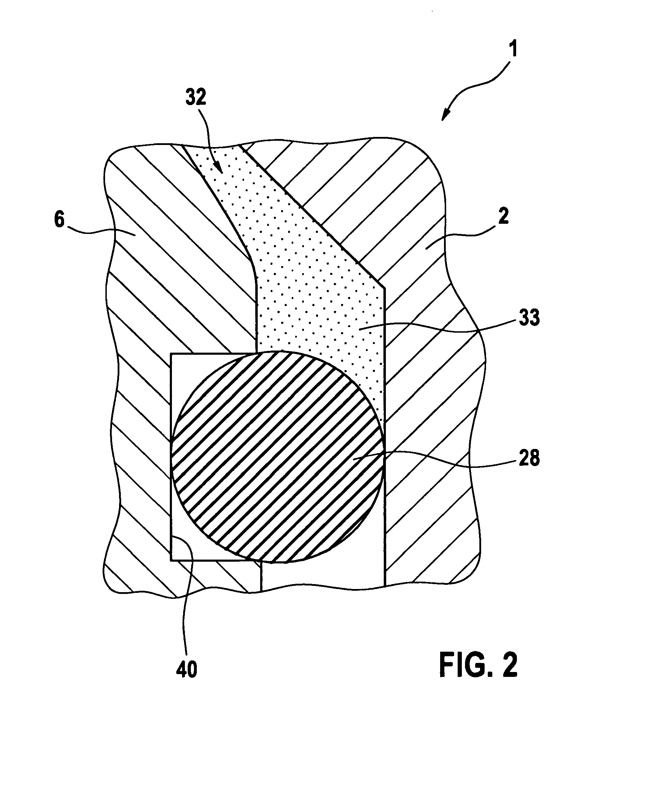

Fig. 2 zeigt den in Fig. 1 mit II bezeichneten Ausschnitt eines Brennstoffeinspritzventils 1 entsprechend einem zweiten Ausführungsbeispiel in einer schematischen Schnittdarstellung. In diesem Ausführungsbeispiel weist das als Aktorfuß ausgestaltete Übergangsstück 6 eine weitere ringförmige Nut 40 auf, in die der Dichtring 28 teilweise eingesetzt ist. Dadurch erfolgt eine zuverlässige Fixierung des Dichtrings 28 relativ zu dem Übergangsstück 6. Dies ermöglicht eine zuverlässige Montage, insbesondere Verpressung des Lagerpulvers zu dem gepressten Pulver 33, und eine zuverlässige Abdichtung beziehungsweise Begrenzung des Volumens 32 über die Lebensdauer des Brennstoffeinspritzventils 1, so dass ein unmittelbarer Kontakt zwischen dem Aktorfuß 6 und dem Ventilgehäuse 2 verhindert ist, da ein Entweichen des gepressten Pulvers 33 aus dem Volumen 32 zumindest im Wesentlichen verhindert ist.

Die Erfindung ist nicht auf die beschriebenen Ausführungsbeispiele beschränkt.

## Patentansprüche

1. Brennstoffeinspritzventil (1), insbesondere Injektor für Brennstoffeinspritzanlagen von luftverdichtenden, selbstzündenden Brennkraftmaschinen, mit einem in einem Ventilgehäuse (2) angeordneten piezoelektrischen Aktor (3) und einem von dem Aktor (3) betätigbaren Ventilschließkörper (16), der mit einer Ventilsitzfläche (18) zu einem Dichtsitz zusammenwirkt, wobei ein als Aktorfuß ausgestaltetes Übergangsstück (6) vorgesehen ist,
**dadurch gekennzeichnet,**
**dass** zwischen dem Aktorfuß (6) und dem Ventilgehäuse (2) ein zusammengepresstes Pulver (33) vorgesehen ist, das eine mittelbare Lagerung des Aktorfußes (6) in dem Ventilgehäuse (2) ermöglicht, und dass der Aktor (3) über dem in dem zusammengepressten Pulver (33) gelagerten Aktorfuß (6) mittelbar an dem Ventilgehäuse (2) abgestützt ist.

2. Brennstoffeinspritzventil nach Anspruch 1,
**dadurch gekennzeichnet,**
**dass** zumindest ein elastischer Dichtring (28, 31) zwischen dem Aktorfuß (6) und dem Ventilgehäuse (2) vorgesehen ist, der ein Volumen (32) begrenzt, in dem das gepresste Pulver (33) angeordnet ist.

3. Brennstoffeinspritzventil nach Anspruch 1 oder 2,
**dadurch gekennzeichnet,**
**dass** der Aktorfuß (6) zumindest abschnittsweise von einer Hülse (25) umgeben ist und dass der Dichtring (28) an einer der Hülse (25) vorgesehenen Auskragung (27) abgestützt ist.

4. Brennstoffeinspritzventil nach Anspruch 1 oder 2, **dadurch gekennzeichnet,**
**dass** der Aktorfuß (6) zumindest eine ringförmige Nut (30, 40) aufweist, in die der Dichtring (28, 31) teilweise eingesetzt ist.

5. Brennstoffeinspritzventil nach einem der Ansprüche 1 bis 4,
**dadurch gekennzeichnet,**
**dass** das gepresste Pulver (33) zumindest teilweise als metallisches Pulver ausgebildet ist.

6. Brennstoffeinspritzventil nach Anspruch 5,
**dadurch gekennzeichnet,**
**dass** das metallische Pulver ein Eisenpulver und/oder ein Stahlpulver und/oder ein Aluminiumpulver aufweist.

7. Brennstoffeinspritzventil nach einem der Ansprüche 1 bis 6,
**dadurch gekennzeichnet,**
**dass** das gepresste Pulver (33) zumindest teilweise als nicht metallisches Pulver ausgebildet ist.

8. Brennstoffeinspritzventil nach Anspruch 7,
**dadurch gekennzeichnet,**
**dass** das nicht metallische Pulver ein Siliciumoxid und/oder ein Magnesiumoxid und/oder ein Aluminiumoxid aufweisen.

9. Brennstoffeinspritzventil nach einem der Ansprüche 1 bis 8,
**dadurch gekennzeichnet,**
**dass** eine Partikelgröße des gepressten Pulvers kleiner ist als 0,5 mm.

10. Brennstoffeinspritzventil nach einem der Ansprüche 1 bis 9,
**dadurch gekennzeichnet,**
**dass** die Verpressung des Pulvers (33) über eine Vorspannkraft erfolgt, die zum Vorspannen des Aktors (3) dient.

## Claims

1. Fuel injection valve (1), in particular an injector for fuel injection systems of air-compressing, auto-ignition internal combustion engines, having a piezoelectric actuator (3) arranged in a valve housing (2) and a valve closing body (16) which can be actuated by the actuator (3) and interacts with a valve seat face (18) to form a sealing seat, wherein provision is made of a transition piece (6) in the form of an actuator foot,
**characterized**
**in that** a compacted powder (33) is provided between the actuator foot (6) and the valve housing (2) and makes it possible for the actuator foot (6) to be supported indirectly in the valve housing (2), and in that the actuator (3) is supported indirectly on the valve housing (2) by way of the actuator foot (6) supported in the compacted powder (33).

2. Fuel injection valve according to Claim 1, **characterized**
**in that** at least one elastic sealing ring (28, 31) is provided between the actuator foot (6) and the valve housing (2) and delimits a volume (32) in which the pressed powder (33) is arranged.

3. Fuel injection valve according to Claim 1 or 2, **characterized**
**in that** the actuator foot (6) is surrounded at least in certain portions by a sleeve (25), and in that the sealing ring (28) is supported on a projection (27) provided on the sleeve (25).

4. Fuel injection valve according to Claim 1 or 2, **characterized**
**in that** the actuator foot (6) has at least one annular groove (30, 40), into which the sealing ring (28, 31) is partially inserted.

5. Fuel injection valve according to one of Claims 1 to 4,
**characterized**
**in that** the pressed powder (33) is at least partially in the form of metallic powder.

6. Fuel injection valve according to Claim 5, **characterized**
**in that** the metallic powder comprises an iron powder and/or a steel powder and/or an aluminium powder.

7. Fuel injection valve according to one of Claims 1 to 6,
**characterized**
**in that** the pressed powder (33) is at least partially in the form of non-metallic powder.

8. Fuel injection valve according to Claim 7, **characterized**
**in that** the non-metallic powder comprises a silicon oxide and/or a magnesium oxide and/or an aluminium oxide.

9. Fuel injection valve according to one of Claims 1 to 8,
**characterized**
**in that** a particle size of the pressed powder is smaller than 0.5 mm.

10. Fuel injection valve according to one of Claims 1 to 9,
**characterized**
**in that** the powder (33) is pressed by way of a preload force, which serves to preload the actuator (3).

## Revendications

1. Soupape d'injection de combustible (1), en particulier injecteur pour des installations d'injection de combustible de moteurs à combustion interne à allumage spontané et à compression d'air, avec un actionneur piézoélectrique (3) disposé dans un corps de soupape (2) et un corps de fermeture de soupape (16) actionnable par l'actionneur (3), qui coopère avec une face de siège de soupape (18) pour former un siège étanche, dans laquelle il est prévu une pièce de transition (6) réalisée sous la forme d'un pied d'actionneur, **caractérisée en ce qu'**il est prévu entre le pied d'actionneur (6) et le corps de soupape (2) une poudre comprimée (33), qui permet un appui indirect du pied d'actionneur (6) dans le corps de soupape (2), et **en ce que** l'actionneur (3) est appuyé indirectement sur le corps de soupape (2) au moyen du pied d'actionneur (6) supporté dans la poudre comprimée (33).

2. Soupape d'injection de combustible selon la revendication 1, **caractérisée en ce qu'**il est prévu, entre le pied d'actionneur (6) et le corps de soupape (2), au moins un joint torique élastique (28, 31), qui limite un volume (32) dans lequel la poudre comprimée (33) est logée.

3. Soupape d'injection de combustible selon la revendication 1 ou 2, **caractérisée en ce que** le pied d'actionneur (6) est entouré, au moins localement, par une douille (25) et **en ce que** le joint torique (28) est appuyé sur une collerette (27) prévue sur la douille (25).

4. Soupape d'injection de combustible selon la revendication 1 ou 2, **caractérisée en ce que** le pied d'actionneur (6) présente au moins une rainure annulaire (30, 40), dans laquelle le joint torique (28, 31) est partiellement engagé.

5. Soupape d'injection de combustible selon l'une quelconque des revendications 1 à 4, **caractérisée en ce que** la poudre comprimée (33) est constituée au moins en partie de poudre métallique.

6. Soupape d'injection de combustible selon la revendication 5, **caractérisée en ce que** la poudre métallique présente une poudre de fer et/ou une poudre d'acier et/ou une poudre d'aluminium.

7. Soupape d'injection de combustible selon l'une quelconque des revendications 1 à 6, **caractérisée en ce que** la poudre comprimée (33) est constituée au moins en partie par une poudre non métallique.

8. Soupape d'injection de combustible selon la revendication 7, **caractérisée en ce que** la poudre non métallique présente un oxyde de silicium et/ou un oxyde de magnésium et/ou un oxyde d'aluminium.

9. Soupape d'injection de combustible selon l'une quelconque des revendications 1 à 8, **caractérisée en ce qu'**une taille de particules de la poudre comprimée est inférieure à 0,5 mm.

10. Soupape d'injection de combustible selon l'une quelconque des revendications 1 à 9, **caractérisée en ce que** la compression de la poudre (33) est effectuée par une force de précontrainte, qui sert pour la précontrainte de l'actionneur (3).
